# EUROPÄISCHE PATENTSCHRIFT

(11) **EP 1 417 406 B1**
(45) Veröffentlichungstag und Bekanntmachung des Hinweises auf die Patenterteilung: **15.10.2008**
(21) Anmeldenummer: 02774517.3
(22) Anmeldetag: 16.08.2002
(51) Int. Cl.: F02M 1/00

(54) **AKTOR ALS ANTRIEBSEINHEIT FÜR EINEN INJEKTOR SOWIE VERFAHREN ZUR HERSTELLUNG DES INJEKTORS**
ACTUATOR ACTING AS A DRIVE UNIT FOR AN INJECTOR AND METHOD FOR THE PRODUCTION OF SAID INJECTOR
ACTIONNEUR SERVANT D'UNITE D'ENTRAINEMENT A UN INJECTEUR ET PROCEDE DE FABRICATION DE L'INJECTEUR

(30) Priorität: 17.08.2001 DE 10140530
(43) Veröffentlichungstag der Anmeldung: 12.05.2004
(73) Patentinhaber: Continental Automotive GmbH, 30165 Hannover (DE)
(72) Erfinder: SCHÜRZ, Willibald, 93188 Pielenhofen (DE); BLOCHING, Wolfgang, 88085 Langenargen (DE); DICK, Jürgen, 93164 Laaber (DE); SIMMET, Martin, 93077 Bad Abbach (DE)
(86) Internationale Anmeldenummer: PCT/EP2002/009178
(87) Internationale Veröffentlichungsnummer: WO 2003/016702

(56) Entgegenhaltungen:
- EP-A- 0 296 628
- EP-A- 0 301 381
- EP-A- 1 106 817
- EP-A- 1 111 230
- DE-C- 19 858 085

## Beschreibung

Die vorliegende Erfindung betrifft einen Aktor als Antriebseinheit eines Injektors insbesondere für ein Speichereinspritzsystem, wobei der Aktor einen in einer Rohrfeder angeordneten Piezostack, eine Kopfplatte und eine Bodenplatte umfasst. Weiterhin betrifft die vorliegende Erfindung ein Verfahren zur Herstellung des Injektors und insbesondere ein Montageverfahren zur Montage des Aktors in einem Injektor.

Aktoren als Antriebseinheit für einen Injektor, welche einen Piezostack verwenden, sind in verschiedenen Ausführungsformen aus dem Stand der Technik bekannt. Dabei ist bei dem aus der EP 1 106 817 A bekannten Injektor der Aktor als Modul ausgebildet, welcher aus dem Piezostack, einer Kopfplatte, einer Bodenplatte und einer Rohrfeder besteht. Zur Befestigung dieses Aktormoduls am eigentlichen Injektor wird das Modul mit dem Injektorgehäuse verschweißt.

Zur Befestigung des Aktormoduls im Aktorgehäuse wird üblicherweise die Kopfplatte mit dem Aktorgehäuse verschweißt. Hierbei werden die vorhandenen Fertigungstoleranzen des Piezoaktors, wie z. B. die Länge des Piezostacks, durch ein positioniertes Verschweißen der Kopfplatte im Aktorgehäuse und durch anschließendes Planschleifen der Aktorbodenplatte gemeinsam mit dem Aktorgehäuse des darin eingeschweißten Piezoaktors, ausgeglichen. Bei den bekannten Aktoren ist einerseits nachteilig, dass dieses Planschleifen des montierten Aktors im Gehäuse einen zusätzlichen Arbeitsschritt erfordert sowie ungewünschte Belastungen des Aktors durch den zusätzlichen Fertigungsschritt hervorgerufen werden. Weiterhin muss auf Grund des Schweißens ein schweißbarer Stahl für die Kopfplatte sowie das Aktorgehäuse verwendet werden. Hierbei tritt weiter eine ungewünschte Wärmebelastung des Aktors auf und es können insbesondere Probleme an der Schweißnaht auftreten. Weiterhin benötigt die bekannte Anordnung des Aktors einen relativ großen Bauraum.

Es ist daher Aufgabe der vorliegenden Erfindung, einen Aktor als Antriebseinheit für einen Injektor bereitzustellen, welcher einen einfacheren und kostengünstigen Aufbau aufweist. Weiterhin ist es Aufgabe der vorliegenden Erfindung, ein verbessertes Herstellverfahren für den Injektor bereitzustellen.

Diese Aufgabe wird durch einen Aktor mit den Merkmalen des Patentanspruchs 1 bzw. ein Verfahren mit den Merkmalen des Patentanspruchs 18 gelöst. Vorteilhafte Weiterbildungen sind Gegenstand der abhängigen Ansprüche.

Der erfindungsgemäße Aktor als Antriebseinheit für einen Injektor mit den Merkmalen des Patentanspruchs 1 hat den Vorteil, dass er in das Injektorgehäuse integriert ist. Dadurch weist der erfindungsgemäße Aktor einen einfachen Aufbau und eine verringerte Teileanzahl auf. Insbesondere kann auf das im Stand der Technik verwendete Aktorgehäuse verzichtet werden. Weiterhin ist der erfindungsgemäße Aktor sehr einfach und kostengünstig herstellbar, da die Kopfplatte des Aktors mittels verstemmten Bereichen unmittelbar am Injektorgehäuse befestigt wird. Dadurch kann auf das im Stand der Technik verwendete, aufwändige Schweißen zur Befestigung des Aktors verzichtet werden. Weiterhin ist erfindungsgemäß eine lageoptimale Befestigung des Aktors im Injektorgehäuse möglich. Hierzu wird der Aktor vor dem Verstemmen im Injektorgehäuse an seiner vorbestimmten Position positioniert und anschließend mittels Verstemmen befestigt. Dadurch kann zum einen auf die aufwändige Nachbearbeitung der Bodenplatte des Aktors verzichtet werden und zum anderen ergibt sich durch die Positionierung und die anschließende Befestigung mittels der verstemmten Bereiche keine nachteilige Addition von herstellungsbedingten Toleranzen am Injektor. Hierzu wird der Aktor an seiner Kopfplatte mittels einem oder mehreren verstemmten Bereichen unmittelbar am Injektorgehäuse befestigt. Da weiter auf das im Stand der Technik verwendete Schweißen verzichtet werden kann, kann an Stelle eines Einsatzstahles für das Injektorgehäuse ein Vergütungsstahl verwendet werden, wodurch sich auf Grund des vereinfachten Fertigungsverfahrens für das Injektorgehäuse (keine mehrstufige Wärmebehandlung erforderlich) deutliche Kostenvorteile ergeben. Weiterhin kann durch Verzicht auf das Aktorgehäuse der Aktor einen verringerten maximalen Außendurchmesser aufweisen, so dass die Gesamtabmessungen des Injektors im Vergleich mit dem Stand der Technik verringert werden können und der Injektor kompakter aufgebaut sein kann.

Vorzugsweise sind die verstemmten Bereiche seitlich an der Kopfplatte das Aktors angeordnet. Dadurch kann ein einfaches Verstemmen, beispielsweise mittels seitlich durch das Injektorgehäuse geführten Pressstempeln, ausgeführt werden.

Gemäß einer anderen bevorzugten Ausgestaltung der vorliegenden Erfindung sind die verstemmten Bereiche am oberen, d. h. nach außen gerichteten, Bereich der Kopfplatte angeordnet. Es sei angemerkt, dass die verstemmten Bereiche sowohl am oberen Bereich der Kopfplatte als auch zusätzlich seitlich an der Kopfplatte angeordnet sein können.

Besonders bevorzugt sind die verstemmten Bereiche radial oder im Wesentlichen tangential zum äußeren Umfang der Kopfplatte angeordnet. Insbesondere bei einer tangentialen Anordnung der verstemmten Bereiche zum äußeren Umfang der Kopfplatte kann nach dem Verstemmen eine besonders hohe Haltekraft für die Kopfplatte erreicht werden, da sich an den verstemmten Bereichen nach dem Verstemmen ein keilförmiger verstemmter Materialbereich ergibt. Dieser keilförmige Materialbereich stützt sich nach außen zum Injektorgehäuse und nach innen zur Kopfplatte ab. Dabei bleibt die vorteilhafte Wirkung der keilförmigen Verstemmung auch nach dem Verstemmvorgang erhalten.

Um eine möglichst geringe Teileanzahl aufzuweisen, sind die verstemmten Bereiche vorzugsweise aus Material des Injektorgehäuses gebildet. Hierzu können beispielsweise am Injektorgehäuse Sacklochbohrungen vorgesehen werden, wobei das Material am Ende der Sacklochbohrung zum Verstemmen mit der Kopfplatte des Aktors verwendet wird.

Gemäß einer anderen bevorzugten Ausgestaltung der vorliegenden Erfindung sind die verstemmten Bereiche aus einem Zusatzmaterial gebildet. Dadurch ist es möglich, das Zusatzmaterial derart auszuwählen, dass es die bestmöglichen Anforderungen hinsichtlich des Verstemmens erfüllen kann. Dadurch ergibt sich auch ein höherer Freiheitsgrad hinsichtlich der Auswahl des Materials für das Injektorgehäuse, da nicht mehr unmittelbar Material des Injektorgehäuses zum Verstemmen verwendet wird. Das Zusatzmaterial zum Verstemmen kann beispielsweise in Durchgangsbohrungen positioniert sein, welche im Injektorgehäuse ausgebildet sind und mittels Pressstempeln verstemmt werden.

Um eine besonders sichere und feste Verbindung an den verstemmten Bereichen zu ermöglichen, ist seitlich an der Kopfplatte des Aktors eine Oberflächenstrukturierung mit einer geeigneten Profiltiefe zum Verstemmen ausgebildet. Dadurch wird sichergestellt, dass Verstemmaterial beim Verstemmen in die Ausnehmungen der Oberflächenstrukturierung eingepresst wird und dadurch eine sichere Befestigung der Kopfplatte mittels Verstemmen gewährleistet ist.

Besonders bevorzugt ist die Oberflächenstrukturierung an der Kopfplatte als teilweise oder vollständig umlaufende Rillen ausgebildet. Dadurch kann die Oberflächenstrukturierung relativ kostengünstig hergestellt werden. Es sei angemerkt, dass die Oberflächenstrukturierung dabei über die gesamte Höhe der Kopfplatte oder auch nur im Bereich der verstemmten Bereiche gebildet sein kann. Gemäß einer besonders bevorzugten Ausgestaltung der vorliegenden Erfindung ist die Oberflächenstrukturierung an einer zylindrischen Kopfplatte als Gewinde ausgebildet. Dadurch kann die Oberflächenstrukturierung besonders kostengünstig hergestellt werden, indem an der zylindrischen Kopfplatte einfach ein Außengewinde vorgesehen ist.

Bevorzugt ist die Verbindung zwischen der Kopfplatte und dem Injektorgehäuse durch vier verstemmte Bereiche gebildet. Besonders bevorzugt sind die vier verstemmten Bereiche dabei derart angeordnet, dass sich jeweils zwei verstemmte Bereiche gegenüberliegen. Dadurch ergibt sich eine besonders günstige Krafteinleitung und Kraftverteilung auf die Kopfplatte. Weiterhin kann dadurch eine ungewünschten Verformung der Kopfplatte beim Durchführen des Verstemmens verhindert werden.

Um möglichst kostengünstig herstellbar zu sein, sind die Kopfplatte und/oder das Injektorgehäuse vorzugsweise aus einem Vergütungsstahl hergestellt. Besonders bevorzugt wird dabei als Vergütungsstahl 42CrMo4 verwendet. Als Zusatzmaterial für das Verstemmen wird vorzugsweise ein Kaltfließpressstahl, wie z.B. Cq45 verwendet.

Vorteilhaft sind im Injektorgehäuse Aussparungen vorgesehen, an welchen die verstemmten Bereiche angeordnet sind. Die Aussparungen können dabei als Durchgangsbohrung oder als Sacklochbohrungen ausgebildet sein. Besonders bevorzugt dienen die Aussparungen nach dem Verstemmen zusätzlich noch als Verankerung für einen elektrischen Steckanschluss des Aktors. Der Steckanschluss wird dabei nach dem Verstemmen der Kopfplatte des Aktors mit dem Injektorgehäuse an den Aussparungen befestigt. Besonders bevorzugt ist der elektrische Steckanschluss dabei durch eine Kunststoffumspritzung gebildet, wobei der in die Aussparungen eingeführte Kunststoff die Verankerung bildet. Weiterhin werden dadurch die verstemmten Bereiche gut durch den Kunststoff eingekapselt, so dass an diesen Stellen keine Korrosion auftreten kann.

Beim erfindungsgemäßen Verfahren zur Herstellung eines Injektors mit einem Aktor umfasst die Montage des Aktors in einem Injektorgehäuse die folgenden Schritte. Zuerst wird der aus einem in einer Rohrfeder angeordneten Piezostack, einer Kopfplatte und einer Bodenplatte bestehende Aktor vormontiert. Anschließend wird der vormontierte Aktor in einem Injektorgehäuse positioniert, indem die Bodenplatte an ihrer vorbestimmten Position im Injektorgehäuse ausgerichtet wird. Danach wird der Aktor am Injektorgehäuse mittels Verstemmen zwischen der Kopfplatte und dem Injektorgehäuse befestigt. Zum Verstemmen kann dabei Material des Injektorgehäuses und/oder der Kopfplatte und/oder ein zusätzliches Verstemmaterial verwendet werden.

Vorzugsweise umfasst das Verfahren zur Herstellung eines Injektors weiterhin den Schritt des Kunststoffspritzens einer elektrischen Steckverbindung an das Injektorgehäuse, wobei die elektrische Steckverbindung in Aussparungen im Injektorgehäuse verankert ist, welche zum Durchführen des Verstemmens verwendet werden.

Nachfolgend wird die Erfindung anhand von bevorzugten Ausführungsbeispielen in Verbindung mit der Zeichnung beschrieben. In der Zeichnung ist:
Figur 1 eine schematische Schnittansicht eines Aktors gemäß einem ersten Ausführungsbeispiel der vorliegenden Erfindung;
Figur 2 eine schematische Schnittansicht entlang der Linie A-A von Figur 1;
Figur 3 eine vergrößerte Detailansicht des Details X von Figur 1;
Figur 4 eine schematische Schnittansicht eines Aktors gemäß einem zweiten Ausführungsbeispiel der vorliegenden Erfindung; Figur 5 eine schematische Schnittansicht entlang der Linie B-B von Figur 4;
Figur 6 eine schematische perspektivische, teilweise geschnittene Ansicht eines Injektors mit einem Aktor gemäß einem dritten Ausführungsbeispiel der vorliegenden Erfindung; und
Figur 7 eine schematische Schnittansicht des in Figur 6 gezeigten Aktors.

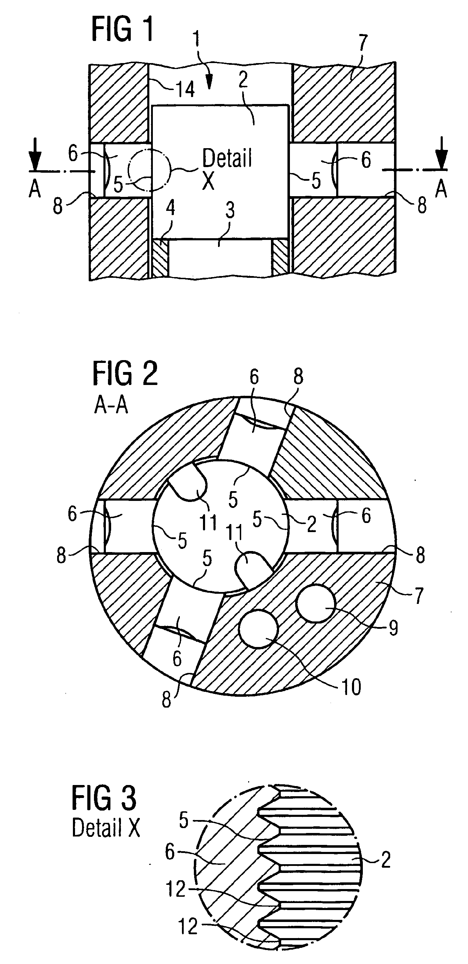

Nachfolgend wird unter Bezugnahme auf die Figuren 1 bis 3 ein Aktor 1 gemäß einem ersten Ausführungsbeispiel der vorliegenden Erfindung beschrieben.

Wie in Figur 1 dargestellt, ist der Aktor 1 in einer Montagebohrung 14 eines Injektorgehäuses 7 angeordnet. Der Aktor 1 besteht aus einer Kopfplatte 2, einem Piezostack 3, welcher in einer Rohrfeder 4 angeordnet ist, und einer nicht dargestellten Bodenplatte: Über die Bodenplatte ist der Aktor 1 in bekannte Weise mit einem Übersetzer zur Übersetzung des Aktorhubes verbunden, um eine Einspritznadel des Injektors von ihrem Sitz abzuheben und eine Einspritzung von Kraftstoff in einen Brennraum auszuführen bzw. zu beenden.

Wie insbesondere aus den Figuren 1 und 2 ersichtlich ist, sind im Injektorgehäuse 7 vier Aussparungen 8 ausgebildet. Die Aussparungen 8 sind als Durchgangsbohrungen ausgeführt und münden in der Montagebohrung 14 des Injektorgehäuses 7. In jeder Aussparung 8 ist jeweils ein Zusatzmaterial 6 angeordnet, welches zum Verstemmen der Kopfplatte 2 des Aktors mit dem Injektorgehäuse 7 verwendet wird. Somit ergeben sich zwischen der Kopfplatte 2 und dem Injektorgehäuse 7 vier verstemmte Bereiche 5 (vgl. Figur 2).

Wie insbesondere in Figur 2 gezeigt, sind jeweils zwei verstemmte Bereiche 5 derart angeordnet, dass sie sich um 180° am Injektorgehäuse 7 gegenüberliegen. Dadurch ergibt sich eine optimale Krafteinleitung und -verteilung auf die Kopfplatte 2. In Figur 3 ist ein verstemmter Bereich 5 vergrößert dargestellt. Wie in Figur 3 gezeigt, sind am Außenumfang der Kopfplatte 2 eine Vielzahl von Rillen 12 ausgebildet, welche parallel zueinander angeordnet sind. Dabei verlaufen die Rillen 12 um den gesamten Aussenumfang der zylindrischen Kopfplatte 2. Diese Rillen 12 stellen eine Oberflächenstrukturierung der Kopfplatte 2 bereit, um eine geeignete Profiltiefe zum Verstemmen sicherzustellen. Wie in Figur 3 gezeigt, ist nach dem Verstemmvorgang das Zusatzmaterial 6 in den Rillen 12 angeordnet, so dass eine sichere Befestigung des Aktors 1 an dem Injektorgehäuse 7 sichergestellt werden kann.

Wie aus Figur 2 ersichtlich ist, sind in der Kopfplatte 2 weiterhin zwei Kabeldurchführungen 11 vorgesehen, um eine elektrische Verbindung für den Piezostack bereitzustellen. Weiterhin sind im Injektorgehäuse 7 eine Hochdruckbohrung 9 und eine Leckagebohrung 10 vorgesehen.

Um den als vormontierte Baugruppe vorbereiteten Aktor 1 im Injektorgehäuse 7 zu befestigen, wird zuerst der Aktor 1 im Injektorgehäuse 7 in der Montagebohrung 14 angeordnet. Dabei wird der Aktor 1 derart positioniert, dass die nicht dargestellte Bodenplatte in ihrer vorbestimmten Position ausgerichtet wird. Anschließend werden die vier Zusatzmaterialien 6 in die Aussparungen 8 im Injektorgehäuse 7 angeordnet und mittels Eindrücken eines Pressstempels verstemmt. Dadurch entstehen vier verstemmte Bereiche 5 zwischen dem Zusatzmaterial 6 und der Kopfplatte 2 bzw. dem Zusatzmaterial 6 und dem Injektorgehäuse 7. Als Zusatzmaterial für das Verstemmen wird vorzugsweise ein Kaltfließpressstahl verwendet, welcher hervorragende Verstemmeigenschaften aufweist.

Dadurch kann erfindungsgemäß der Aktor 1 lageoptimal im Injektor befestigt werden, ohne dass aufwändige Nachbearbeitungen notwendig sind. Insbesondere kann erfindungsgemäß eine nachteilige Addition unterschiedlicher Toleranzen der einzelnen Bauteile durch das Verstemmen verhindert werden. Genauer kann erfindungsgemäß ein Ausgleich von Fertigungstoleranzen des Aktors 1, wie z. B. Längentoleranzen des Piezostacks 3, der Kopfplatte 2 oder der Bodenplatte, durch ein exaktes Positionieren des vormontierten Aktors in Bezug auf eine im Injektorgehäuse 7 angeordnete Referenzfläche erfolgen. Weiterhin kann in den Aussparungen 8 nach dem Verstemmen ein elektrischer Steckeranschluss beispielsweise mittels Kunststoffspritzen einfach verankert werden.

Der dargestellte Aktor 1 wird insbesondere in einem Injektor für ein Speichereinspritzsystem, wie beispielsweise einem Common-Rail-System, verwendet. Durch die integrale Anordnung des Aktors 1 im Injektorgehäuse 7 kann der Injektor besonders kleine und kompakte Abmessungen aufweisen. Weiterhin kann durch das Verstemmen ein Vergütungsstahl verwendet werden, so dass sich eine einfachere Herstellung sowohl der Kopfplatte 2 als auch des Injektorgehäuses 7 ergeben.

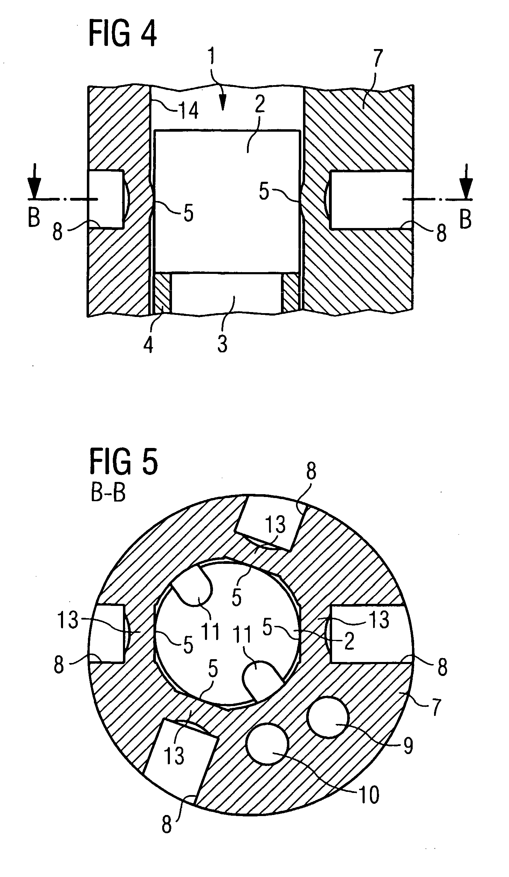

Nachfolgend wird unter Bezugnahme auf die Figuren 4 und 5 ein Aktor 1 gemäß einem zweiten Ausführungsbeispiel der vorliegenden Erfindung beschrieben. Dabei werden für gleichartige Teile die gleichen Bezugszeichen verwendet.

Der Aktor 1 des zweiten Ausführungsbeispiels entspricht im Wesentlichen dem des ersten Ausführungsbeispiels. Im Unterschied zum ersten Ausführungsbeispiel sind im zweiten Ausführungsbeispiel jedoch keine zusätzlichen Verstemmaterialien vorgesehen, sondern als Material für das Verstemmen wird Material 13 des Injektorgehäuses 7 verwendet. Hierzu sind im Injektorgehäuse 7 Sackbohrungen 8 vorgesehen, so dass am Ende jeder Sacklochbohrung jeweils ein Materialanteil 13 stehen bleibt, mit welchem das Verstemmen der Kopfplatte 2 erfolgt. Ansonsten entspricht der Aktor des zweiten Ausführungsbeispiels dem ersten Ausführungsbeispiel, so dass auf die dort gegebene Beschreibung verwiesen werden kann.

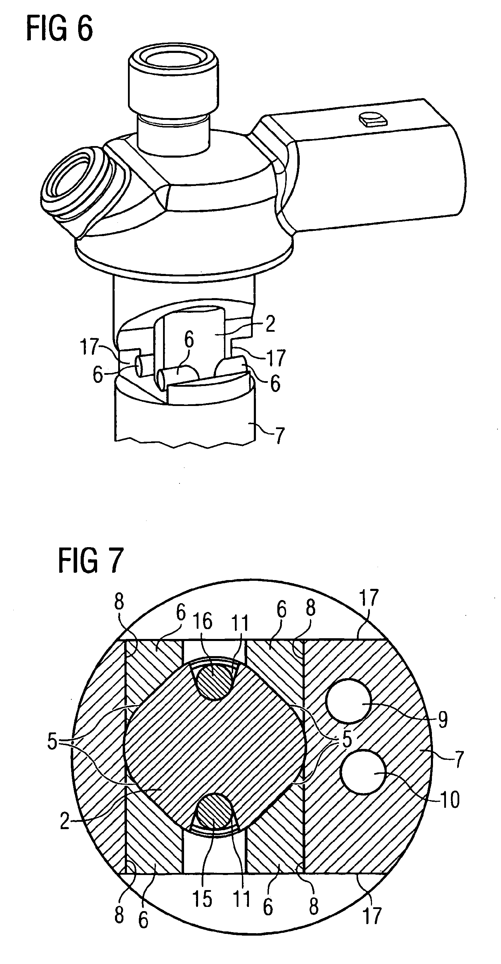

Nachfolgend wird unter Bezugnahme auf die Figuren 6 und 7 ein Aktor gemäß einem dritten Ausführungsbeispiel der vorliegenden Erfindung beschrieben, wobei gleichartige Teile wiederum mit den gleichen Bezugszeichen wie in den vorhergehenden Ausführungsbeispielen bezeichnet sind.

Der Aktor des dritten Ausführungsbeispiels entspricht im Wesentlichen dem des ersten Ausführungsbeispiels, wobei anstelle von radialen Bohrungen tangentiale Bohrungen 8 zum äußeren Umfang der Kopfplatte 2 gebildet sind. Wie aus den Figuren 6 und 7 ersichtlich ist, sind die Aussparungen 8 an abgeflachten Bereichen 17 des Injektorgehäuses 7 gebildet. Dabei sind jeweils zwei Aussparungen 8 einander gegenüberliegend angeordnet, sodass die vier Aussparungen 8 mittels nur zwei Bohrungen erzeugt werden können, wodurch sich herstellungsbedingte Kostenvorteile ergeben. Die Aussparungen 8 sind dabei tangential zur Bohrung für die Aufnahme des Aktors gebildet.

In Figur 7 ist der verstemmte Zustand der Kopfplatte 2 dargestellt. Wie aus Figur 7 ersichtlich ist, werden als Verstemmmaterial zylinderförmige Verstemmstifte 6, vorzugsweise aus dem gut umformbaren Material Cq 45, verwendet. Nach dem Verstemmen sind die zylinderförmigen Verstemmstifte 6 derart verformt, dass sie zwischen der Kopfplatte 2 und dem Injektorgehäuse 7 jeweils keilförmige verstemmte Bereiche 5 bilden. Diese keilförmigen verstemmten Bereiche 5 stützen sich nach außen hin zum Injektorgehäuse 7 und nach innen hin zur Kopfplatte 2 ab. Die Verstemmung erfolgt somit im Wesentlichen tangential zur Außenseite der Kopfplatte 2. Es sei angemerkt, dass für eine verbesserte Keilwirkung der äußere Umfang der Kopfplatte 2 mit abgeflachten Bereichen ausgebildet sein kann. Ebenfalls kann eine Oberflächenstrukturierung, beispielsweise in Form einer Riffelung o.ä., an der Kopfplatte 2 vorgesehen sein. Die abgeflachten Bereiche 17 am Injektorgehäuse 7 können ebenfalls als Verankerung, beispielsweise für einen elektrischen Steckanschluß o.ä., verwendet werden.

In Figur 7 sind weiterhin die in den Kabeldurchführungen 11 angeordneten Kabel 15 und 16 für die elektrische Verbindung des Piezostacks dargestellt.

Somit betrifft die vorliegende Erfindung einen Aktor 1 als Antriebseinheit für einen Injektor, insbesondere für ein Speichereinspritzsystem, wobei der Aktor einen in einer Rohrfeder 4 angeordneten Piezostack 3, eine Kopfplatte 2 und eine Bodenplatte umfasst. Der Aktor ist an der Kopfplatte 2 mittels wenigstens einem verstemmtem Bereich 5 unmittelbar an einem Injektorgehäuse 7 befestigt. Durch das Verstemmen ergibt sich dabei eine einfache und kostengünstige Herstellbarkeit des Injektors.

Die vorliegenden Erfindung ist nicht auf die dargestellten Ausführungsbeispiele beschränkt. Es können verschiedene Abweichungen und Änderungen ausgeführt werden, die in den Schutzbereich der beigefügten Ansprüche fallen, ohne den Erfindungsumfang zu verlassen.

## Patentansprüche

1. Aktor als Antriebseinheit eines Injektors, insbesondere für ein Speichereinspritzsystem, wobei der Aktor (1) einen in einer Rohrfeder (4) angeordneten Piezostack (3), eine Kopfplatte (2) und eine Bodenplatte umfasst, wobei der Aktor (1) an der Kopfplatte (2) an einem Injektorgehäuse befestigt ist, **dadurch gekennzeichnet, dass** der Aktor (1) an der Kopfplatte (2) mittels verstemmten Bereichen (5) am Injektorgehäuse (7) befestigt ist.

2. Aktor nach Anspruch 1, **dadurch gekennzeichnet, dass** die verstemmten Bereiche (5) seitlich an der Kopfplatte (2) angeordnet sind.

3. Aktor nach Anspruch 1 oder 2, **dadurch gekennzeichnet, dass** die verstemmten Bereiche (5) am oberen Bereich der Kopfplatte (2) angeordnet sind.

4. Aktor nach einem der Ansprüche 1 bis 3, **dadurch gekennzeichnet, dass** die verstemmten Bereiche (5) radial zum Außenumfang der Kopfplatte (2) angeordnet sind.

5. Aktor nach einem der Ansprüche 1 bis 3, **dadurch gekennzeichnet, dass** die verstemmten Bereiche (5) im Wesentlichen tangential zum äußeren Umfang der Kopfplatte (2) angeordnet sind.

6. Aktor nach einem der Ansprüche 1 bis 5, **dadurch gekennzeichnet, dass** die verstemmten Bereiche (5) aus Material des Injektorgehäuses (7) gebildet sind.

7. Aktor nach einem der Ansprüche 1 bis 5, **dadurch gekennzeichnet, dass** die verstemmten Bereiche (5) aus einem Zusatzmaterial (6) gebildet sind.

8. Aktor nach einem der Ansprüche 1 bis 7, **dadurch gekennzeichnet, dass** an der Kopfplatte (2) eine Oberflächenstrukturierung mit einer geeigneten Profiltiefe zum Verstemmen ausgebildet ist.

9. Aktor nach Anspruch 8, **dadurch gekennzeichnet, dass** die Oberflächenstrukturierung an der Kopfplatte (2) als teilweise oder vollständig umlaufende Rillen (12) ausgebildet ist.

10. Aktor nach Anspruch 8, **dadurch gekennzeichnet, dass** die Kopfplatte (2) zylindrisch ausgebildet ist und die Oberflächenstrukturierung an der Kopfplatte (2) als Außengewinde ausgebildet ist.

11. Aktor nach einem der Ansprüche 1 bis 10, **dadurch gekennzeichnet, dass** die Verbindung zwischen der Kopfplatte (2) und dem Injektorgehäuse (7) durch vier verstemmte Bereiche (5) gebildet ist.

12. Aktor nach Anspruch 11, **dadurch gekennzeichnet, dass** die vier verstemmten Bereiche (5) derart angeordnet sind, dass sich jeweils zwei verstemmte Bereiche (5) an der Kopfplatte (2) gegenüberliegen.

13. Aktor nach einem der Ansprüche 1 bis 12, **dadurch gekennzeichnet, dass** die Kopfplatte (2) und/oder das Injektorgehäuse (7) aus einem Vergütungsstahl hergestellt sind.

14. Aktor nach Anspruch 13, **dadurch gekennzeichnet, dass** als Vergütungsstahl 42CrMo4 verwendet wird.

15. Aktor nach einem der Ansprüche 1 bis 14 , **dadurch gekennzeichnet, dass** im Injektorgehäuse (7) Aussparungen (8) vorgesehen sind, an welchen die verstemmten Bereiche (5) angeordnet sind.

16. Aktor nach Anspruch 15, **dadurch gekennzeichnet, dass** die Aussparungen (8) als Verankerung für einen elektrischen Steckanschluss des Aktors dienen.

17. Aktor nach Anspruch 16, **dadurch gekennzeichnet, dass** der elektrische Steckanschluss als Kunststoffumspritzung ausgebildet ist.

18. Verfahren zur Herstellung eines Injektors mit einem Aktor (1), wobei die Montage des Aktors (1) zur Betätigung des Injektors in einem Injektorgehäuse (7) die Schritte umfasst:
- Vormontieren des aus einem in einer Rohrfeder (4) angeordneten Piezostack (3), einer Kopfplatte (2) und einer Bodenplatte bestehenden Aktors (1),
- Positionieren des vormontierten Aktors (1) in dem Injektorgehäuse (7) durch Ausrichten des Aktors, insbesondere durch Ausrichten der Bodenplatte, an seiner vorbestimmten Position und
- Befestigen des Aktors (1) am Injektorgehäuse (7), **darduch gekennzeichnet**, dass der Aktor (1) mittels Verstemmen zwischen der Kopfplatte (2) und dem Injektorgehäuse (7) am Injektorgehäuse (7) befestigt wird.

19. Verfahren nach Anspruch 18, **dadurch gekennzeichnet, dass** zum Verstemmen Material der Kopfplatte (2) und/oder Material (13) des Injektorgehäuses und/oder ein Zusatzmaterial (6) verwendet wird.

20. Verfahren nach Anspruch 18 oder 19, **dadurch gekennzeichnet, dass** zum Verstemmen im Inj ektorgehäuse (7) Aussparungen (8) gebildet sind, welche nach dem Verstemmen zur Verankerung eines kunststoffgespritzten elektrischen Steckanschlusses verwendet werden.

## Claims

1. Actuator acting as a drive unit of an injector, especially for an accumulator injection system, whereby the actuator (1) comprises a piezostack (3) disposed in a tube spring (4), a top plate (2) and a bottom plate, with the top plate (2) of the actuator (1) being fastened on an injector housing, **characterised in that** the top plate (2) of the actuator (1) is fixed on the injector housing (7) by means of caulked areas (5).

2. Actuator according to claim 1, **characterised in that** the caulked areas (5) are disposed on the sides of the top plate (2).

3. Actuator according to claim 1 or 2, **characterised in that** the caulked areas (5) are disposed on the upper area of the top plate (2).

4. Actuator according to one of claims 1 to 3, **characterised in that** the caulked areas (5) are disposed radially in respect of the outer periphery of the top plate (2).

5. Actuator according to one of claims 1 to 3, **characterised in that** the caulked areas (5) are disposed essentially tangentially in respect of the outer periphery of the top plate (2).

6. Actuator according to one of claims 1 to 5, **characterised in that** the caulked areas (5) are formed from the material of the injector housing (7).

7. Actuator according to one of claims 1 to 5, **characterised in that** the caulked areas (5) are formed from a filler material (6).

8. Actuator according to one of claims 1 to 7, **characterised in that** a surface structure is configured on the top plate (2) with a suitable profile depth for caulking.

9. Actuator according to claim 8, **characterised in that** the surface structure on the top plate (2) is configured as partially or wholly circumferential grooves (12).

10. Actuator according to claim 8, **characterised in that** the top plate (2) is configured as a cylinder and the surface structure on the top plate (2) is configured as an external thread.

11. Actuator according to one of claims 1 to 10, **characterised in that** the connection between the top plate (2) and the injector housing (7) is formed by four caulked areas (5).

12. Actuator according to claim 11, **characterised in that** the four caulked areas (5) are disposed in such a way that two caulked areas (5) lie opposite each other on the top plate (2) in each instance.

13. Actuator according to one of claims 1 to 12, **characterised in that** the top plate (2) and/or the injector housing (7) are made of a tempering steel.

14. Actuator according to claim 13, **characterised in that** 42CrMo4 is used as the tempering steel.

15. Actuator according to one of claims 1 to 14, **characterised in that** cutouts (8) are provided in the injector housing (7), at which the caulked areas (5) are disposed.

16. Actuator according to claim 15, **characterised in that** the cutouts (8) serve as anchorage points for an electric plug-type connection of the actuator.

17. Actuator according to claim 16, **characterised in that** the electrical plug-type connection is configured as a plastic extrusion coating.

18. Method for producing an injector with an actuator (1), whereby the assembly of the actuator (1) to activate the injector in an injector housing (7) comprises the following stages:
- Pre-assembly of the actuator (1) comprising a piezostack (3) disposed in a tube spring (4), a top plate (2) and a bottom plate,
- Positioning of the pre-assembled actuator (1) in the injector housing (7) by lining up the actuator, especially by lining up the bottom plate with its predefined position and
- Fixing the actuator (1) on the injector housing (7), **characterised in that** the actuator (1) is fixed on the injector housing (7) by means of caulking between the top plate (2) and the injector housing (7).

19. Method according to claim 18, **characterised in that** the material of the top plate (2) and/or the material (13) of the injector housing and/or a filler material (6) is used for caulking.

20. Method according to claim 18 or 19, **characterised in that** cutouts (8) are formed in the injector housing (7) for caulking and these are used after caulking to anchor a plastic injected electrical plug-type connection.

## Revendications

1. Actionneur formant une unité d'entraînement d'un injecteur, en particulier d'un système d'injection à accumulation, l'actionneur (1) comportant un empilage piézoélectrique (3), disposé dans un tube-ressort (4), une plaque de tête (2) et une plaque de fond, l'actionneur (1) étant fixé, au niveau de la plaque de tête (2), sur un boîtier d'injecteur, **caractérisé en ce que** l'actionneur (1) est fixé au niveau de la plaque de tête (2) sur le boîtier d'injecteur (7) au moyen de zones matées (5).

2. Actionneur selon la revendication 1, **caractérisé en ce que** les zones matées (5) sont disposées latéralement sur la plaque de tête (2).

3. Actionneur selon la revendication 1 ou 2, **caractérisé en ce que** les zones matées (5) sont disposées au niveau de la partie supérieure de la plaque de tête (2).

4. Actionneur selon l'une quelconque des revendications 1 à 3, **caractérisé en ce que** les zones matées (5) sont disposées radialement par rapport à la périphérie extérieure de la plaque de tête (2).

5. Actionneur selon l'une quelconque des revendications 1 à 3, **caractérisé en ce que** les zones matées (5) sont disposées sensiblement tangentiellement à la périphérie extérieure de la plaque de tête (2).

6. Actionneur selon l'une quelconque des revendications 1 à 5, **caractérisé en ce que** les zones matées (5) sont réalisées dans le matériau du boîtier d'injecteur (7).

7. Actionneur selon l'une quelconque des revendications 1 à 5, **caractérisé en ce que** les zones matées (5) sont réalisées dans un matériau supplémentaire (6).

8. Actionneur selon l'une quelconque des revendications 1 à 7, **caractérisé en ce que** sur la plaque de tête (2) est réalisée une structuration superficielle avec une profondeur de profil appropriée pour le matage.

9. Actionneur selon la revendication 8, **caractérisé en ce que** la structuration superficielle sur la plaque de tête (2) est réalisée sous forme de rainures (12) partiellement ou totalement périphériques.

10. Actionneur selon la revendication 8, **caractérisé en ce que** la plaque de tête (2) est cylindrique et la structuration superficielle sur la plaque de tête (2) est réalisée sous forme de filetage extérieur.

11. Actionneur selon l'une quelconque des revendications 1 à 10, **caractérisé en ce que** la liaison entre la plaque de tête (2) et le boîtier d'injecteur (7) est formée par quatre zones matées (5).

12. Actionneur selon la revendication 11, **caractérisé en ce que** les quatre zones matées (5) sont disposées de telle sorte que respectivement deux zones matées (5) sont situées face à face sur la plaque de tête (2).

13. Actionneur selon l'une quelconque des revendications 1 à 12, **caractérisé en ce que** la plaque de tête (2) et/ou le boîtier d'injecteur (7) sont réalisés dans un acier de traitement.

14. Actionneur selon la revendication 13, **caractérisé en ce que** l'acier de traitement utilisé est le 42CrMo4.

15. Actionneur selon l'une quelconque des revendications 1 à 14, **caractérisé en ce que** dans le boîtier d'injecteur (7) sont prévus des évidements (8), au niveau desquels sont disposées les zones matées (5).

16. Actionneur selon la revendication 15, **caractérisé en ce que** les évidements (8) font fonction d'ancrage pour un connecteur électrique à broches de l'actionneur.

17. Actionneur selon la revendication 16, **caractérisé en ce que** le connecteur électrique à broches est réalisé par moulage par injection de matière synthétique.

18. Procédé de réalisation d'un injecteur avec un actionneur (1), le montage de l'actionneur (1), destiné à actionner l'injecteur, dans un boîtier d'injecteur (7) comportant les étampes :
- assemblage préalable de l'actionneur (1) formé par un empilage piézoélectrique (3), disposé dans un tube-ressort (4), une plaque de tête (2) et une plaque de fond,
- positionnement de l'actionneur (1) pré-assemblé dans le boîtier d'injecteur (7) par orientation de l'actionneur, en particulier par orientation de la plaque de fond, dans sa position prédéterminée, et
- fixation de l'actionneur (1) sur le boîtier d'injecteur (7), **caractérisé en ce que** l'actionneur (1) est fixé sur le boîtier d'injecteur (7) par matage entre la plaque de tête (2) et le boîtier d'injecteur (7).

19. Procédé selon la revendication 18, **caractérisé en ce que** pour le matage est utilisé un matériau de la plaque de tête (2) et/ou un matériau (13) du boîtier d'injecteur et/ou un matériau supplémentaire (6).

20. Procédé selon la revendication 18 ou 19, **caractérisé en ce que** des évidements (8) sont formés dans le boîtier d'injecteur (7) pour le matage, lesquels évidements sont utilisés après le matage pour l'ancrage d'un connecteur électrique à broches moulé par injection de matière synthétique.
